# EUROPEAN PATENT APPLICATION

(11) **EP 1 418 497 A2**
(43) Date of publication of application: **12.05.2004**
(21) Application number: 03023899.2
(22) Date of filing: 21.10.2003
(51) Int. Cl.: G06F 7/58

(54) **Method for generating random number and random number generator**

(30) Priority: 06.11.2002 JP 2002322955
(71) Applicant: Niigata University, Niigata City, Niigata Pref., (JP)
(72) Inventor: Saito, Yoshiaki, Niigata City Niigata Pref. (JP)
(74) Representative: von Hellfeld, Axel, Dr. Dipl.-Phys.

(57) **Abstract**

Random control voltages are applied to an oscillating circuit with an oscillation frequency control section from a noise generating circuit to generate random oscillation voltages which correspond to frequency signals from the oscillating circuit. The random oscillation voltages are digitally converted at an A/D converter and input into a personal computer, where a given threshold value is defined to the amplitudes of the random oscillation voltages and numerals "0" and "1" are allotted to the random oscillation voltages on the magnitude relation between the threshold value and the amplitudes of the random oscillation voltages. As a result, a binary random number relating to numerals "0" and "1" can be generated.

## Description

### BACKGROUND OF THE INVENTION

### Field of the Invention:

This invention relates to a method for generating random number and a random number generator which are usable in information industry field such as cryptograph, particularly in prospective quantum computer field.

### Description of the related art:

Random number which is perfectly in disorder and has uniform frequency of appearance is widely available in numerical simulation for social phenomenon, physical phenomenon and the like. The random number also plays an important role in cryptograph, and get a lot of attention in information security field. At present, various generating methods of random number are researched and developed, but can almost generate only pseudorandom number on software algorithm.

As of now, the algorithmic generating method of random number is widely available on a certain level of reliability and high speed random number generation. Generally, however, since the computer can generate only definite range of information, the random number generated by the computer has a given periodicity. Therefore, in numerical simulation, precise solution can not be obtained and in information security, sufficient security can not be realized. In this point of view, random number with more perfect disorder is desired.

Recently, with the development of processing speed and reliability in hardware, a physical generating method of random number has been developed. For example, it is known that random number which is generated on physical phenomenon such as thermoelectron noise or radioactive decay has low predictability to be ideal. However, the physical generating method requires large scaled devices for generating the random number.

### SUMMERY OF THE INVENTION

It is an object of the present invention to provide, with simple and not expensive devices, a new method for generating random number with more perfectly disorder and a random number generator which is utilized in the generating method of random number.

For achieving the above object, this invention relates to a method for generating random number, comprising the steps of:
applying random control voltages to an oscillating circuit with an oscillating frequency control section to generate random oscillation voltages which correspond to frequency signals from the oscillating circuit on the random control voltages, respectively,
defining a given threshold value for amplitudes of the oscillation voltages, and
allotting numerals "0" and "1" to the oscillation voltages on a magnitude relation between the threshold value and the amplitudes of the oscillation voltages to generate a binary random number.

This invention also relates to a random number generator comprising:
an oscillating circuit with an oscillation frequency control section,
a control voltage applying means for applying random control voltages to the oscillating circuit,
a processing means for defining a threshold value to random oscillation voltages which correspond to frequency signals from the oscillating circuit and allotting numerals "0" and "1" to the random oscillation voltages on a magnitude relation between the threshold value and amplitudes of the random oscillation voltages.

The inventor of the present invention has intensely studied to find out a new method to generate a random number with perfectly disorder. In the process of the research and development of the random number generating method, various random number generators usable for the generating method are developed: one is to utilize a given noise generating circuit and the others are to utilize a given oscillating circuit which is switched on/off intermittently and a given bistable multivibrator (Japanese Patent Applications No. 2000-222525, 2002-221194 and 2002-282842). With the above-mentioned conventional random number generators, however, the generating speed of random number is low around 100/sec. For the practical use of the conventional random number generators, however, it is desired to develop the generating speed of random number.

In this point of view, the inventor had also intensely studied to develop the generating speed of random number. As a result, the inventor had found out that if an oscillation frequency controlling section is provided into a given oscillating circuit and random control voltages are applied to the oscillating circuit from a given noise generating circuit, random oscillation voltages are generated from the oscillating circuit at high speed. Therefore, if a predetermined threshold value is defined for the amplitudes of the oscillation voltages conventionally, a binary random number can be generated at high speed on the magnitude relation between the amplitudes of the oscillation voltages and the threshold value, to conceive this invention.

According to the present invention, as mentioned above, since the binary random number can be generated in disorder at high speed, the processing speed in the information industry field such as cryptograph, particularly in prospective quantum computer field can be enhanced conspicuously.

### BRIEF DESCRIPTION OF THE DRAWINGS

For better understanding of the present invention, reference is made to the attached drawings, wherein
Fig. 1 is a structural view of a preferable random number generator according to the present invention,
Fig. 2 is a circuit diagram of an oscillating circuit in the random number generator of the present invention,
Fig. 3 is a circuit diagram of another oscillating circuit in the random number generator of the present invention,
Fig. 4 is a circuit diagram of a noise generating circuit in the random number generator of the present invention,
Fig. 5 is a circuit diagram of an oscillating circuit modified from the oscillating circuit illustrated in Fig. 2,
Fig. 6 is a binary frequency distribution of the random number generated by the generating method and the generator of the present invention.

### DESCRIPTION OF THE PREFERRED EMBODIMENTS

This invention will be described in detail with reference to the accompanying drawings.

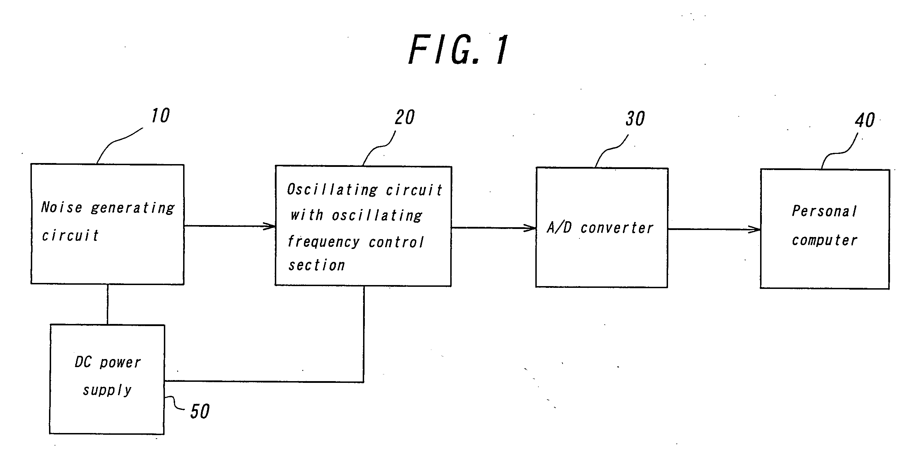

Fig. 1 is a structural view of a preferable random number generator according to the present invention. In the random number generator illustrated in Fig. 1, a noise generating circuit 10, an oscillating circuit 20 with oscillation frequency control section, an A/D converter 30 and a personal computer 40 which are successively connected with one another. Since the oscillating circuit 20 includes the oscillation frequency control section, the oscillating circuit 20 oscillates signals with different frequencies on the amplitudes of the control voltages from the oscillation frequency control section. A DC power supply 50 is connected to the noise generating circuit 10.

When a given voltage is applied to the noise generating circuit 10 from the DC power supply 50, random voltage signals are generated from the noise generating circuit 10, and then, applied as control voltages to the oscillating circuit 20. In this case, signals with different frequencies are oscillated from the oscillating circuit 20. When the oscillation voltages of the signals are detected, therefore, the oscillation voltages are also fluctuated randomly on the random voltage signals.

Then, the oscillation voltages are input into the A/D converter 30 and digitally converted, and then, input into the personal computer 40. In this case, if a predetermined threshold value is defined for the amplitudes of the oscillation voltages and the magnitude relation between the threshold value and the amplitudes of the oscillation voltages is determined, and numeral "1" is allotted to the oscillation voltages with amplitudes higher than the threshold value and numeral "0" is allotted to the oscillation voltages with amplitudes lower than the threshold value, the numeral "1" and "0" can be randomly generated and thus, the binary random number can be generated.

Herein, in the random number generator illustrated in Fig. 1, since the oscillation frequency control section is incorporated in the oscillating circuit 20, the random oscillation voltages can be generated at high speed on the application of the random control voltages from the noise generating circuit 10, and thus, the binary random number relating to numerals "1" and "0" can be generated at high speed.

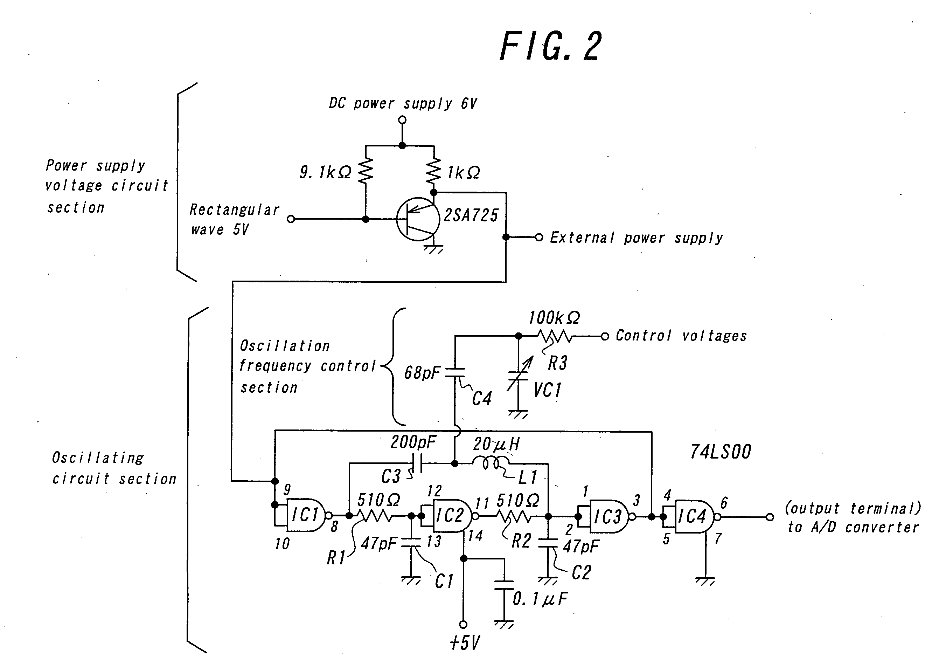

Fig. 2 is a circuit diagram of an embodiment of the oscillating circuit 20. In Fig. 2, the oscillating circuit 20 is constructed as a digital oscillating circuit, and includes a power supply voltage circuit section and an oscillating circuit section.

In the oscillating circuit section, an outside positive feedback circuit and an inside positive feedback circuit are incorporated. The outside positive feedback circuit is constructed of TTL logics IC1-IC3, resistances R1(510Ω) and R2(510Ω), condensers C1(47pF) and C2(47pF). The inside positive feedback circuit is constructed of the TTL logic IC2, the resistances R1 and R2, the condensers C1 and C2, a condenser C3(200pF), and a coil L1(20µH).
A variable capacitance diode VC1 and a resistance R3(100kΩ) are connected to the joint between the coil L1 and the condenser C3 via a condenser C4(68pF).
In this embodiment, the oscillation frequency control section of the oscillating circuit 20 is constructed of the condenser C4, the resistance R3 and the variable capacitance diode VC1.

When a given power supply voltage is applied to the oscillating circuit section from the power supply voltage circuit section, the oscillating circuit section is repeatedly operated in feedback and amplified in the oscillating circuit section, to be oscillated as a frequency signal outside therefrom.

In this case, when random control voltages are input into the oscillating circuit 20 illustrated in Fig. 2 from the noise generating circuit 10 via the variable capacitance diode VC1, the capacitance of the variable capacitance diode VC1 is fluctuated randomly on the random control voltages. Therefore, the frequencies of voltage signals to be generated and oscillated are randomly fluctuated to provide random voltage signals with different frequencies at high speed from the oscillating circuit section of the oscillating circuit 20. The random voltage signals are input into the A/D converter 30 and digitally converted, and then, processed in the personal computer 40 to set a predetermined threshold value for the amplitudes of the random voltage signals, so that the binary random number can be generated at high speed.

In Fig. 2, although in the oscillating circuit 20, the power supply voltage circuit section is provided in addition to the oscillating circuit section, the power supply voltage may be input directly into the oscillating circuit 20 (oscillating circuit section) from the external power supply without the power supply voltage circuit section.

In the oscillating circuit 20 illustrated in Fig. 2, a rectangular wave is input into the power supply voltage circuit section, and the power supply voltage is intermittently oscillated to generate the random voltage signals with different frequencies. Without the rectangular wave, however, the power supply voltage is constantly generated and applied to the oscillating circuit section. In the latter case, the random voltage signals with different frequencies can be generated on the random fluctuation of the capacitance of the variable capacitance diode VC1 in the oscillation frequency control section, and thus, the binary random number can be generated at high speed.

Herein, the intermittent oscillation of the power supply voltage can enhance the random degree of the random voltage signals, and thus, the binary random number with much disorder can be easily generated.

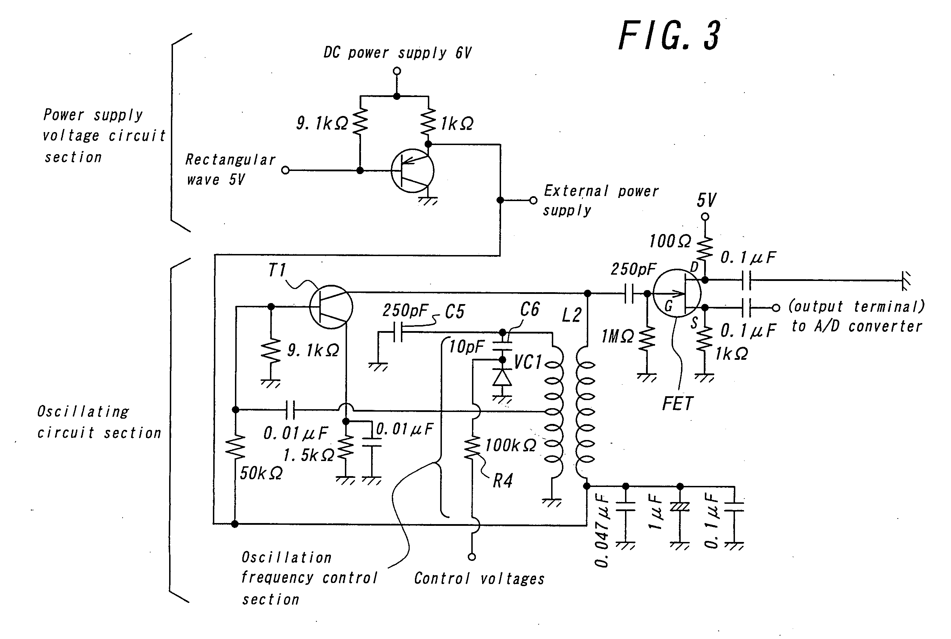

Fig. 3 is a circuit diagram of another embodiment of the oscillating circuit 20. In Fig. 3, the oscillating circuit 20 is constructed as an analog oscillating circuit. When a given power supply voltage is applied to the oscillating circuit section from the power supply voltage circuit section of the oscillating circuit 20, the oscillating circuit section is operated in positive feedback and amplified through the collector of a transistor T1, a coil L2 and the base of the transistor T1, to be oscillated. The oscillation frequency of the oscillating circuit section is determined on the coil L2 and a condenser C5(250pF). In this embodiment, the oscillation frequency control section of the oscillating circuit 20 is constructed of a condenser C6(10pF), a variable capacitance diode VC2 and a resistance R4(100kΩ), which are connected with the condenser C6.

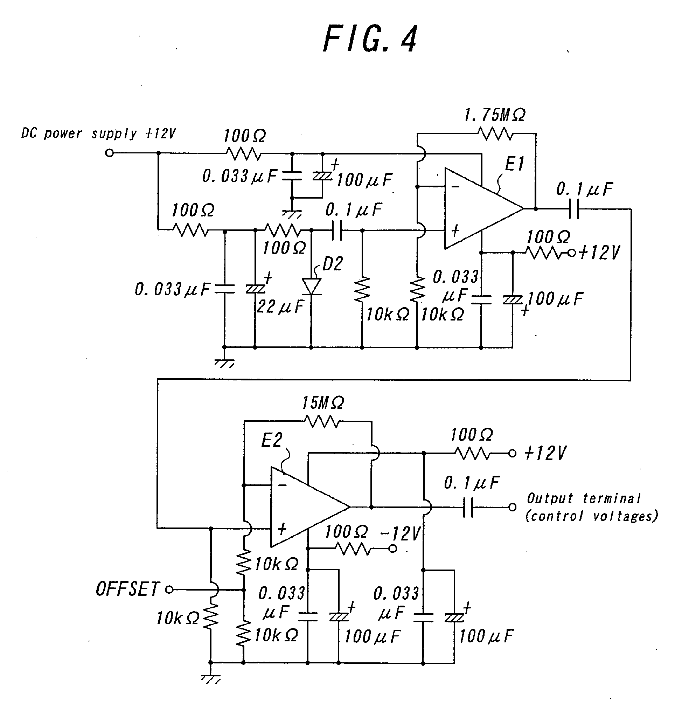

Random control voltages are input into the oscillating circuit 20 illustrated in Fig. 3 from the noise generating circuit 10 illustrated in Fig. 4 via the variable capacitance diode VC2, the capacitance of the variable capacitance diode VC2 is randomly fluctuated on the random fluctuation of the random control voltages. Therefore, the frequencies of voltage signals to be generated and oscillated are randomly fluctuated to provide random voltage signals with different frequencies at high speed from the oscillating circuit section of the oscillating circuit 20. The random voltage signals are input into the A/D converter 30 and digitally converted, and then, processed in the personal computer 40 to set a predetermined threshold value for the amplitudes of the random voltage signals, so that the binary random number can be generated at high speed.

In Fig. 3, although in the oscillating circuit 20, the power supply voltage circuit section is provided in addition to the oscillating circuit section, the power supply voltage may be input directly into the oscillating circuit 20 (oscillating circuit section) from the external power supply without the power supply voltage circuit section.

In the oscillating circuit 20 illustrated in Fig. 3, a rectangular wave is input into the power supply voltage circuit section, and the power supply voltage is intermittently oscillated to generate the random voltage signals with different frequencies. Without the rectangular wave, however, the power supply voltage is constantly generated and applied to the oscillating circuit section. In the latter case, the random voltage signals with different frequencies can be generated on the random fluctuation of the capacitance of the variable capacitance diode VC2 in the oscillation frequency control section, and thus, the binary random number can be generated at high speed.

Herein, the intermittent oscillation of the power supply voltage can enhance the random degree of the random voltage signals, and thus, the binary random number with much disorder can be easily generated.

Fig. 4 is a circuit diagram of an embodiment of the noise generating circuit 10. In this embodiment, the noise generating circuit 10 is constructed of two feedback amplifying circuits which are arranged stepwise in Fig. 4. When a given DC voltage is applied to the upper feedback amplifying circuit, minute noises are generated at a diode D2, and then, amplified at operational amplifiers E1 and E2 so that the peak voltages of the noise signals are amplified to several volts. The thus obtained amplified noise signals are applied as control signals to the oscillating circuit 20 illustrated in Fig. 1.

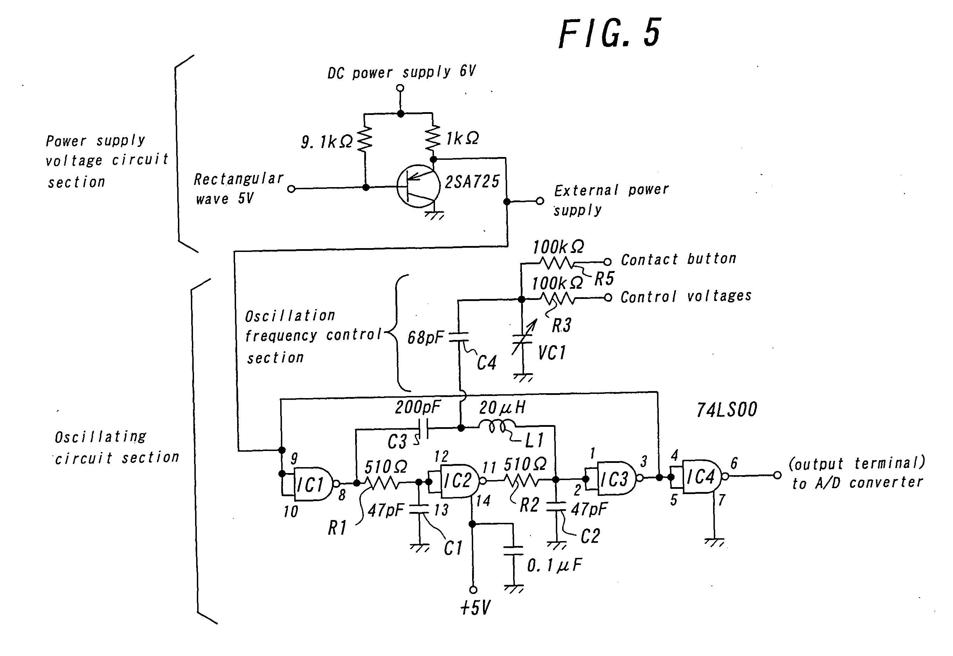

Fig. 5 is a circuit diagram of a modified embodiment of the oscillating circuit 20 illustrated in Fig. 2. In the oscillating circuit 20 illustrated in Fig. 5, a contact button is provided via a resistance R5 in the oscillating frequency control section, which is different from the one illustrated in Fig. 2. In this case, the output terminal of the oscillating circuit 20 illustrated in Fig. 2 or 3 is connected to the contact button of the oscillating circuit 20 illustrated in Fig. 5, the two oscillating circuits can be connected with each other.

In normal operation, since the oscillating circuit itself may be fluctuated to some degree, the frequencies of the oscillation signals to be generated and oscillated may be also fluctuated. Therefore, if two oscillating circuits are connected as mentioned above, the frequencies of the oscillation signals to be generated at and oscillated from the rear oscillating circuit 20 illustrated in Fig. 5 are fluctuated more randomly than the ones of the front oscillating circuit 20 illustrated in Fig. 2 or 3. As a result, if the oscillation voltages of the oscillation signals from the oscillating circuit 20 illustrated in Fig. 5 is detected and compared on a predetermined threshold value, the binary random number with much random relating to numerals "1" and "0" can be generated easily at high speed.

In the above-mentioned embodiment relating to the combination of two oscillating circuits, control voltages are applied only to the rear oscillating circuit, but may be applied only to the front oscillating circuit. Moreover, if another control voltage is applied to the front oscillating circuit, the random oscillation signals can be generated and oscillated through the front and the rear oscillating circuits. In this case, the random degree of the binary random number can be enhanced.

In the above-mentioned embodiment, two oscillating circuits are combined, but three or over oscillating circuits may be combined with one another. In this case, the random degree of the binary random number can be more enhanced. With the combination of three oscillating circuits, the oscillating circuits may be connected with one another in ring connection (first oscillating circuit-second oscillating circuit-third oscillating circuit) or in cross connection (first oscillating circuit→second oscillating circuit, second oscillating circuit-first oscillating circuit and/or second oscillating circuit-third oscillating circuit, third oscillating circuit-second oscillating circuit and/or third oscillating circuit-first oscillating circuit, first oscillating circuit-third oscillating circuit).

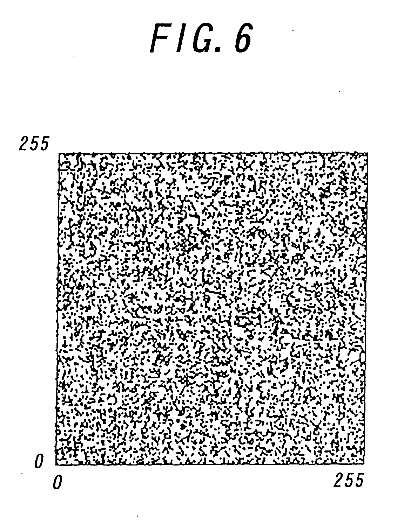

Fig. 6 is a binary frequency distribution of the random number generated by the oscillating circuit 20 illustrated in Fig. 2 and the noise generating circuit 10 illustrated in Fig. 4. As is apparent from Fig. 6, no stripe pattern is created and only dots are created, so that it is turned out that a given binary random number is generated by the oscillating circuit 20 and the noise generating circuit 10.

Although the present invention was described in detail with reference to the above examples, this invention is not limited to the above disclosure and every kind of variation and modification may be made without departing from the scope of the present invention.

As mentioned above, according to the present invention, with simple and not expensive devices, a new method for generating random number with more perfectly disorder and a random number generator which is utilized in the generating method of random number can be provided.

## Claims

1. A method for generating random number, comprising the steps of:
applying random control voltages to an oscillating circuit with an oscillating frequency control section to generate random oscillation voltages which correspond to frequency signals from said oscillating circuit on said random control voltages, respectively,
defining a given threshold value for amplitudes of said oscillation voltages, and
allotting numerals "0" and "1" to said oscillation voltages on a magnitude relation between said threshold value and said amplitudes of said oscillation voltages to generate a binary random number.

2. The generating method as defined in claim 1, wherein said oscillation frequency control section includes a variable capacitance diode.

3. The generating method as defined in claim 1 or 2, wherein said random control voltages are generated at a noise generating circuit.

4. The generating method as defined in claim 3, wherein said noise generating circuit includes a noise generating element and a noise amplifying element.

5. The generating method as defined in claim 4, wherein said noise generating element includes a diode.

6. The generating method as defined in claim 4 or 5, wherein said noise amplifying element includes an operational amplifier.

7. The generating method as defined in any one of claims 1-6, wherein said oscillating circuit is constructed as a digital oscillating circuit.

8. The generating method as defined in any one of claims 1-6, wherein said oscillating circuit is constructed as an analog oscillating circuit.

9. The generating method as defined in any one of claims 1-8, wherein said oscillation voltages are digitally converted at an A/D converter.

10. The generating method as defined in any one of claims 1-9, wherein said oscillating circuit includes a first oscillating circuit and a second oscillating circuit electrically connected with said first oscillating circuit, and said random control voltages are applied to said second oscillating circuit to generate and oscillate frequency signals from said second oscillating circuit, and said threshold value is defined for amplitudes of oscillation voltages of said frequency signals to generate said binary random number through the allocation of numerals "0" and "1" on a magnitude relation between said threshold value and said amplitudes of said oscillation voltages.

11. The generating method as defined in any one of claims 1-9, wherein said oscillating circuit includes a first oscillating circuit and a second oscillating circuit electrically connected with said first oscillating circuit, and said random control voltages are applied to said first oscillating circuit to generate and oscillate frequency signals from said second oscillating circuit, and said threshold value is defined for amplitudes of oscillation voltages of said frequency signals to generate said binary random number through the allocation of numerals "0" and "1" on a magnitude relation between said threshold value and said amplitudes of said oscillation voltages.

12. The generating method as defined in any one of claims 1-9, wherein said oscillating circuit includes a first oscillating circuit and a second oscillating circuit electrically connected with said first oscillating circuit, and said random control voltages are applied to said first oscillating circuit and said second oscillating circuit to generate and oscillate frequency signals from said second oscillating circuit, and said threshold value is defined for amplitudes of oscillation voltages of said frequency signals to generate said binary random number through the allocation of numerals "0" and "1" on a magnitude relation between said threshold value and said amplitude of said oscillation voltages.

13. A random number generator comprising:
an oscillating circuit with an oscillation frequency control section,
a control voltage applying means for applying random control voltages to said oscillating circuit,
a processing means for defining a threshold value to random oscillation voltages which correspond to frequency signals from said oscillating circuit and allotting numerals "0" and "1" to said random oscillation voltages on a magnitude relation between said threshold value and amplitudes of said random oscillation voltages.

14. The random number generator as defined in claim 13, wherein said oscillation frequency control section includes a variable capacitance diode.

15. The random number generator as defined in claim 13 or 14, wherein said control voltage applying means includes a noise generating circuit.

16. The random number generator as defined in claim 15, wherein said noise generating circuit includes a noise generating element and a noise amplifying element.

17. The random number generator as defined in claim 16, wherein said noise generating element includes a diode.

18. The random number generator as defined in claim 16 or 17, wherein said noise amplifying element includes an operational amplifier.

19. The random number generator as defined in any one of claims 13-18, wherein said oscillating circuit is constructed as a digital oscillating circuit.

20. The random number generator as defined in any one of claims 13-18, wherein said oscillating circuit is constructed as an analog oscillating circuit.

21. The random number generator as defined in any one of claims 13-20, wherein said oscillation voltages are digitally converted at an A/D converter.

22. The random number generator as defined in any one of claims 13-21, wherein said oscillating circuit includes a first oscillating circuit and a second oscillating circuit electrically connected with said first oscillating circuit, and said control voltage applying means is connected with said second oscillating circuit to apply said control voltages to said second oscillating circuit and to oscillate frequency signals from said second oscillating circuit.

23. The random number generator as defined in any one of claims 13-21, wherein said oscillating circuit includes a first oscillating circuit and a second oscillating circuit electrically connected with said first oscillating circuit, and said control voltage applying means is connected with said first oscillating circuit to apply said control voltages to said first oscillating circuit and to oscillate frequency signals from said second oscillating circuit.

24. The random number generator as defined in any one of claims 13-21, wherein said oscillating circuit includes a first oscillating circuit and a second oscillating circuit electrically connected with said first oscillating circuit, and said control voltage applying means is connected with said first oscillating circuit and said second oscillating circuit to apply said control voltages to said first oscillating circuit and said second oscillating circuit and to oscillate frequency signals from said second oscillating circuit.
